# EUROPEAN PATENT APPLICATION

(11) **EP 1 073 109 A2**
(43) Date of publication of application: **31.01.2001**
(21) Application number: 00306349.2
(22) Date of filing: 26.07.2000
(51) Int. Cl.: H01L 21/316

(54) **Single phase perovskite ferroelectric film on platinum electrode and method for forming same**

(30) Priority: 28.07.1999 US 363245
(71) Applicant: SHARP KABUSHIKI KAISHA, Osaka 545-8522 (JP)
(72) Inventor: Li, Tingkai, Vancouver, WA 98683 (US); Zhang, Fengyan, Vancouver, WA 98683 (US); Hsu, Sheng Teng, Camas, WA 98607 (US)
(74) Representative: West, Alan Harry

(57) **Abstract**

A ferroelectric device is provided with a single phase, high quality, ferroelectric film orientationally grown on a Pt electrode. The Pt electrode is orientationally grown on a material that has the lattice structure desired in the ferroelectric film. The Pt electrode adopts the lattice structure of the underlying layer, so that lattice mismatch between the Pt and the ferroelectric film is minimized. This adjustment in the Pt lattice structure permits the formation of single phase perovskite ferroelectric films, on Pt electrodes, at low deposition temperatures. As a result, ferroelectric devices with low leakage current, and completely saturated, square, symmetrical hysteresis loops are formed. A method of forming the ferroelectric film, of the above-mentioned ferroelectric device, is also provided.

## Description

The present invention relates generally to the field of integrated circuit (IC) fabrication and, more particularly, to a ferroelectric film formed on a platinum (Pt) electrode which has single phase perovskite characteristics.

In recent years, the interest in ferroelectric materials for nonvolatile random access memory application (NvRAMs) has intensified. To meet the requirements for these memory applications, ferroelectric capacitors should have small size, low coercive field, high remanent polarization, low fatigue rate, and low leakage current. Some of the candidate ferroelectric materials under investigation for these applications are perovskite ferroelectrics, such as PbZr₁₋ₓTiₓO₃ (PZT) or doped PZT, BaTiO₃, SrTiO₃, etc. These materials have a high Curie temperature and promising ferroelectrical properties such as large remanent polarization and low coercive field. However, these perovskite ferroelectrics are known to suffer from serious degradation problems including fatigue (loss of switchable polarization with increasing reversal of polarization), aging, and leakage current, which affect the lifetime of the devices.

Another ferroelectric material is SrBi₂Ta₂O₉ (SBT), which has fatigue-free properties. However, SBT must be deposited or annealed at temperatures greater than 750°C, which limits its applications. Lead Germanate (PGO) films are another alternative material being investigated.

Ferroelectric thin films are usually oxide ceramics with high melting temperatures. Therefore, it is very difficult to reduce the deposition temperature lower than 600 °C and still maintain the desired phases, such as in PZT and SBT films. This relationship holds regardless of deposition technique. For the most studied PZT thin films, for example, good electrical properties in conjunction, with deposition temperatures below 600° C have not been reported. This problem could be due to metastable pyrochlore phases which tend to form in this temperature range. Although low temperature depositions are possible using improved precursors or plasma to enhance the dissociation of precursors, very little research in this area has been reported. Recently, the fatigue-free bilayered ferroelectrics, namely SrBi₂Ta₂O₉ or SrBi₂Nb₂O₉, have been produced by MOCVD, sol-gel, and pulse laser deposition. However, the deposition temperatures are still greater than 700 ° C. Further, CVD bilayered ferroelectric thin films need post-annealing temperatures higher than 700 °C for long times (> 1 hr) in order to obtain ferroelectricity.

Platinum (Pt) and other noble metals are used in IC ferroelectric capacitors. The use of noble metals is motivated by their inherent chemical resistance. This property is especially desirable under high temperature oxygen annealing conditions, such as those seen in the fabrication of ferroelectric capacitors. In addition, chemical interaction between noble metals and ferroelectric materials such as perovskite metal oxides, is negligible.

Pt electrodes are widely used in FeRAM and DRAM device applications. Pt is a good barrier electrode, and the surface quality of ferroelectric thin films on Pt electrodes is better than that on other electrodes. But epitaxial films, or even pure phase ferroelectric materials, are difficult to deposit on Pt through low temperature MOCVD processes.

Other problems associated with the annealing of a Pt metal film are peeling, hillock formation, and oxygen diffusion. Peeling and hillock formation are related to the differences in thermal expansion and stress of Pt with neighboring IC layers during high temperature annealing. A layer of Ti overlying the Pt film is known to reduce stress of the Pt film, suppressing hillock formation. Iridium (Ir) and barrier metals have been used as a diffusion barrier to prevent oxygen diffusion.

Experimental results show that epitaxial ferroelectric thin films, such as PZT and PGO, can be grown on Ir electrodes by MOCVD processes. But due to the oxidation of Ir electrodes and diffusion of the IrO₂ into ferroelectric thin films at higher deposition or annealing temperatures, these ferroelectric thin films have higher leakage current. Further, the surface roughness of ferroelectric thin films grown on Ir electrode is higher than that on electrodes such as Pt electrode, which limits the applications of Ir electrodes.

Both Pt and Ir electrodes have a preferred orientation (111). The lattice mismatch between Pt (111) or Ir (111) and various ferroelectric materials such as PZT and PGO are as listed in Table 1. From the table, it can be seen that the lattice mismatch between Ir (111) and ferroelectric materials is smaller than that of Pt (111) and ferroelectric materials.

**TABLE 1**

| LATTICE MISMATCH | | |
|---|---|---|
| Materials | PZT(110) | c·axis oriented PGO |
| Pt (111) | 12.6% | 8.3% |
| Ir (111) | 10.2 | 5.9% |

When PZT is deposited on Pt (111) electrodes at low temperatures, such as 550°C, multiple phases are formed. Namely, both pyrochlore and perovskite (ferroelectric phase) phases result. The single perovskite phase of PZT on Pt can be obtained only at higher deposition temperatures over 500° C, or after annealing over 650° C. For PZT on Ir (111) electrodes, single perovskite (ferroelectric phase) phase is easy to form at both low and high deposition temperatures. For PGO deposition on Ir (111), the single extremely high c-axis oriented PGO can be formed. But for the PGO on Pt (111) electrodes, even it is difficult to form a single PGO phase.

The following co-pending applications, owned by the same assignee as the instant patent application, are related:
1) Serial No. 09/263,595, entitled "Iridium Conductive Electrode/Barrier Structure and Method for Same", invented by Zhang et al., and filed on March 5, 1999, Attorney Docket No. SMT 364;
2) Serial No. 09/263,970, entitled "Iridium Composite Barrier Structure and Method for Same", invented by Zhang et al., and filed on Marsh 5, 1999, Attorney Docket No. SMT 366;
3) Serial No. 09/316,661, entitled "Composite Iridium Barrier Structure with Oxidized Refractory Metal Companion Barrier and Method for Same", invented by Zhang et al., and filed on May 21, 1999, Attorney Docket No. SLA404;
4) Serial No. 09/316,646, entitled "Composite Iridium-Metal-Oxygen Barrier Structure with Refractory Metal Companion Barrier and Method for Same", invented by Zhang et al., and filed on May 21, 1999, Attorney Docket No. SLA405;
5) Serial No. 09/301.435, entitled "Multi-Phase Lead Germanate Film and Deposition Method", invented by Tingkai Li et al., filed on April 28, 1999, Attorney Docket No. SLA400;
6) Serial No. 09/301,420, entitled "C-Axis Oriented Lead Germanate Film and Deposition Method", invented by Tingkai Li et al., filed on April 28, 1999, Attorney Docket No. SLA401;
7) Serial No. 09/302,272, entitled "Epitaxially Grown Lead Germanate Film and Deposition Method", invented by Tingkai Li et al., filed on April 28, 1999, Attorney Docket No. SLA402;
8) Serial No. 09/301,434, entitled "Ferroelastic Lead Germanate Film and Deposition Method", invented by Tingkai Li et al., filed on April 28, 1999, Attorney Docket No. SLA403;

It would be advantageous if a ferroelectric electrode could be fabricated that incorporated the best features of Ir and Pt.

It would be advantageous if epitaxial multilayer electrodes could be used to grow epitaxial or preferred orientation ferroelectric thin films, so that the better ferroelectric properties and film uniformity are obtained.

It would be advantageous if a single phase perovskite film could be formed on a metal electrode at low deposition temperatures. It would be advantageous if this perovskite film could be formed on an electrode of Pt at deposition temperatures of less than 550 degrees C.

It would be advantageous if a ferroelectric film could be deposited on Pt, with the same perovskite properties, as a ferroelectric film deposited on Ir.

Accordingly, in an integrated circuit ferroelectric device, a method for forming a ferroelectric film is provided comprising the steps of:
a) forming a first bottom electrode layer of platinum (Pt) having a first adjusted crystalline lattice structure; and
b) forming a single phase perovskite ferroelectric film overlying the first bottom electrode layer having a second crystalline lattice structure substantially the same as the first adjusted crystalline lattice structure, whereby an electrode having ferroelectric properties is formed on a Pt electrode.

Step b) includes epitaxially growing the ferroelectric film from the Pt bottom electrode layer, whereby a perovskite ferroelectric film is formed on Pt without high temperature annealing.

In some aspects of the invention, Step a) includes epitaxially growing the first bottom electrode layer from an underlying Ir layer having a third crystalline lattice structure which is substantially the same as the Pt first adjusted lattice structure. When a silicon substrate is provided, the Ir layer is epitaxially grown from the underlying silicon substrate. In some aspects of the invention, a preliminary step forms a barrier layer of a material selected from the group consisting of titanium (Ti) and tantalum (Ta) overlying the silicon substrate, having a thickness in the range of approximately 100 to 500 Å.

Step a) includes forming a Pt first bottom electrode layer at a temperature in the range of approximately 100 to 250 degrees C, with a growth rate in the range of approximately 0.1 to 0.5 Å per second, to a thickness in the range of approximately 100 to 1000 Å.

A ferroelectric device is also provided comprising a first bottom electrode layer of epitaxially grown platinum (Pt) having a first adjusted crystalline lattice structure. A single phase perovskite ferroelectric film overlies the first bottom electrode layer having a second lattice structure substantially the same as the first adjusted crystalline lattice structure. In this manner, the device has both good ferroelectric properties and low leakage current. A second bottom electrode layer of iridium (Ir) underlies the first bottom electrode layer having a third crystalline lattice structure substantially the same as the first adjusted lattice structure. The Pt electrode layer has the lattice structure of the Ir electrode layer.

In some aspects of the invention, a barrier layer including a material selected from the group consisting of titanium (Ti) and tantalum (Ta), is interposed between a silicon substrate and the second bottom electrode layer. The ferroelectric film is a material selected from the group consisting of PZT and lead germanate (PGO). In some aspects of the invention, the ferroelectric device further comprises a top electrode overlying the ferroelectric film to form a capacitor.

### Brief Description of the Drawings

Figs. 1, 2 and 3 show the fatigue properties of PZT thin films deposited on electrodes of Ir, Pt and Pt/Ir.

Fig. 4 illustrates that, compared with Ir and Pt electrodes, the PZT film deposited on the Pt/Ir present invention electrode exhibits lower fatigue rates.

Figs. 5, 6, and 7 illustrate the fatigue behavior of PZT thin films on Ir, Pt and Pt/Ir electrodes at a switching voltage of 3V and frequency of 5 kHz.

Fig. 8 illustrates that the fatigue rates of the PZT thin films on Pt decrease with decreasing switching frequency.

Figs. 9 and 10 illustrate the fatigue properties of PZT thin films deposited on Pt and Pt/Ir electrodes at a switching voltage of 5V and switching frequency of 5 kHz.

Fig. 11 illustrates that, compared with the data of the PZT films at a switching voltage of 3V, the fatigue rates of the PZT thin films deposited on both Pt and Pt/Ir increase with increasing switching voltage.

Fig. 12 illustrates the X-ray pattern of present invention PZT thin films deposited at 550°C and annealed at 650°C.

Fig. 13 shows that the hysteresis loop of as-deposited present invention PZT thin films with a 2Pr 60.7 µC/cm² and a 2Ec 76 kV/cm.

Fig. 14 illustrates the hysteresis loop of the present invention thin films after annealing at 650° C for 30 minutes.

Fig. 15 illustrates the hysteresis loops of present invention thin films at various applied voltages.

Fig. 16 illustrates the low leakage current of 6.16 x 10⁻⁷ A/cm² at 100 kV/cm of present invention thin films.

Fig. 17 is the X-ray pattern of Pt, Ir and epitaxial Pt/Ir electrodes.

Fig. 18 is the X-ray patterns of PZT on Pt, Ir and epitaxial Pt-Ir electrodes.

Fig. 19 illustrates steps in a method for forming a ferroelectric film of the present invention in a ferroelectric device.

Fig. 20 illustrates a completed ferroelectric device of the present invention.

The present invention describes a method of depositing epitaxial multilayer and composite electrodes, and then, depositing high quality ferroelectric thin films, such as PbZr₁₋ₓTiₓO₃ (PZT) and Pb₅Ge₃O₁₁ (PGO) thin films, between the epitaxial multilayer and composite electrodes.

The fatigue properties of PZT thin films on three kinds of electrodes of Ir, Pt and multilayer Pt/Ir were investigated at various switching voltages and frequencies. The PZT thin films on Ir electrodes have square and saturated hysteresis loops, but their leakage currents and fatigue rates are very high. The PZT thin films on Pt electrodes have lower leakage currents, but their hysteresis loops are not square and completely saturated. The PZT thin films on the multilayer Pt/Ir electrodes of the present invention have very square and saturated hysteresis loops, and lower leakage currents and fatigue rates. The experimental prccesses and results are as follows.

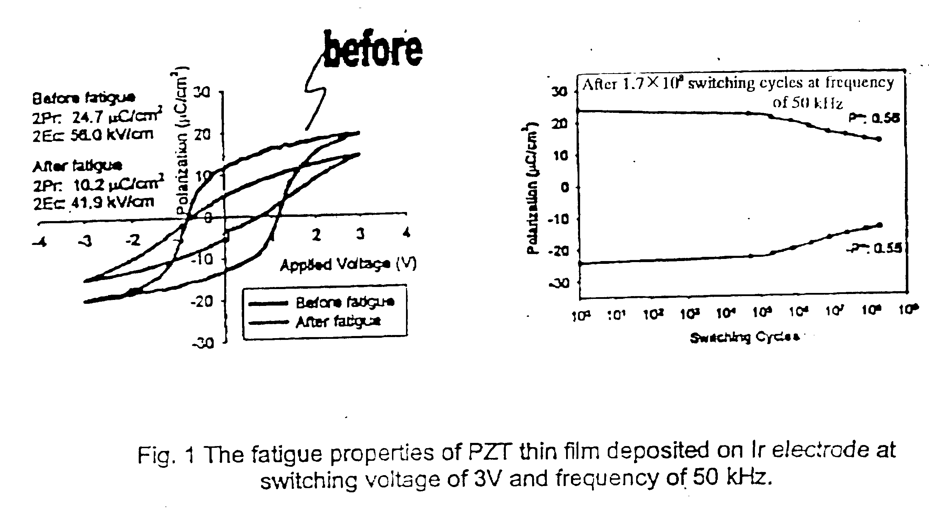

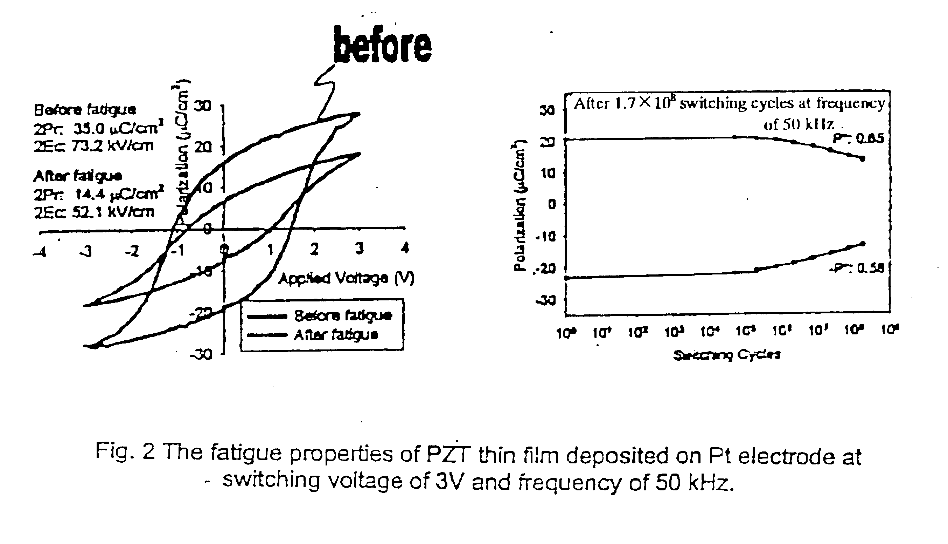

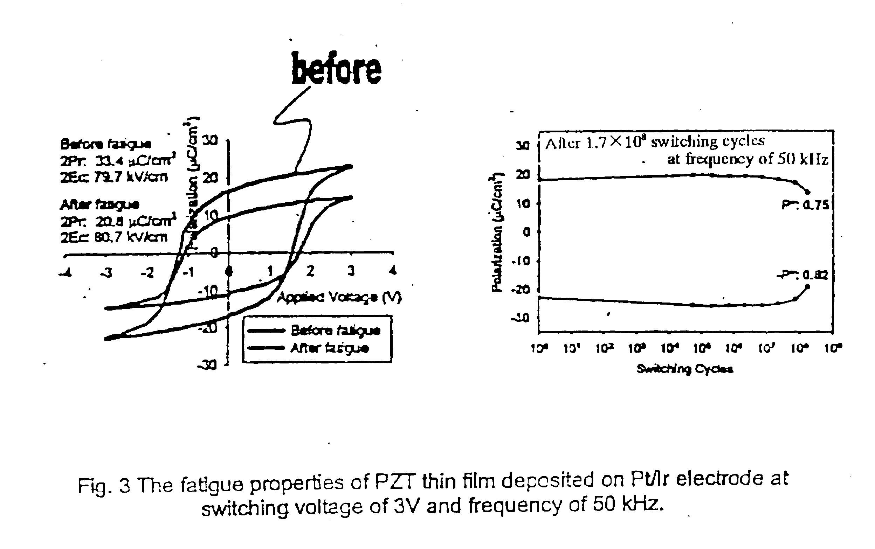

Figs. 1, 2 and 3 show the fatigue properties of PZT thin films deposited on electrodes of Ir, Pt and Pt/Ir. The fatigue properties were measured at a switching voltage of 3V, and a switching frequency of 50kHz. After 1x10⁸ switching cycles test, the normalized retained polarization of PZT thin films on Ir, Pt and Pt/Ir were 0.55, 0.61 and 0.75, respectively. As seen from the experimental results, the PZT thin films on both Ir and Pt/Ir electrodes have square and saturated hysteresis loops, but the hysteresis loop PZT thin film on Pt electrode are not square and not completely saturated.

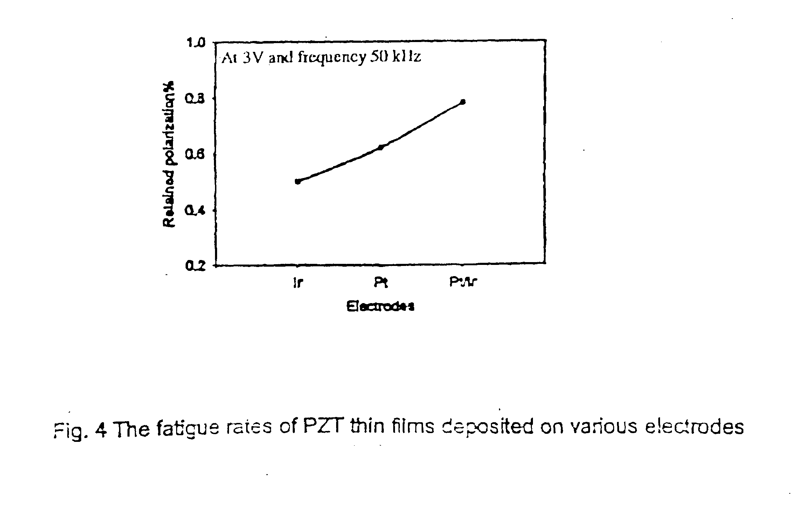

Fig. 4 illustrates that, compared with Ir and Pt electrodes, the PZT film deposited on the Pt/Ir present invention electrode exhibits lower fatigue rates.

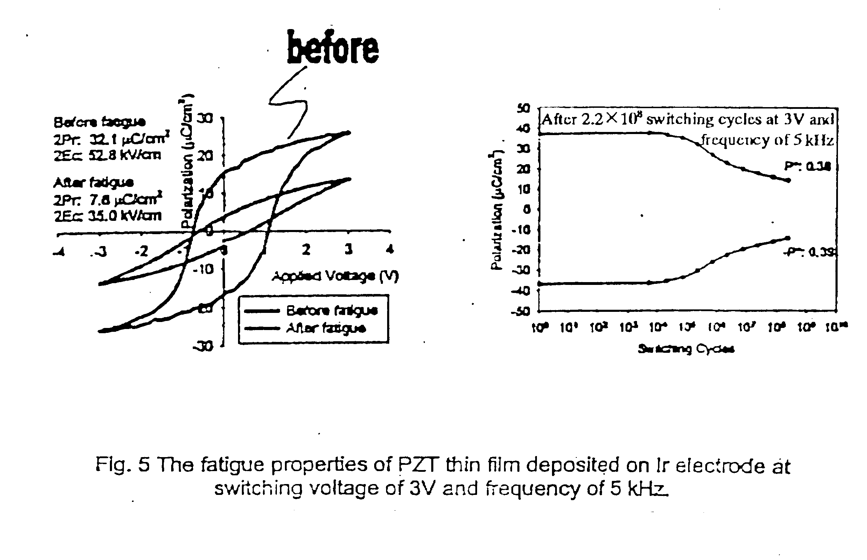

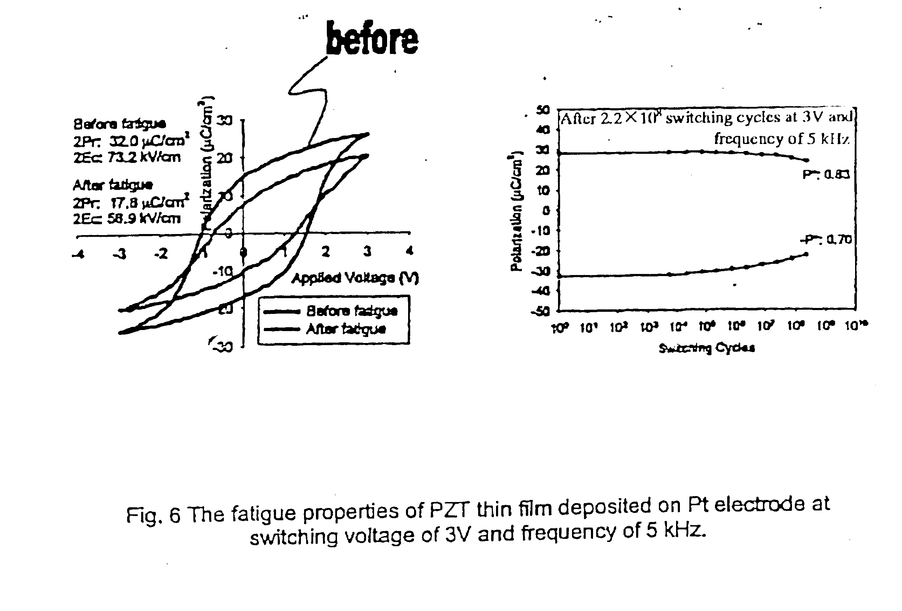

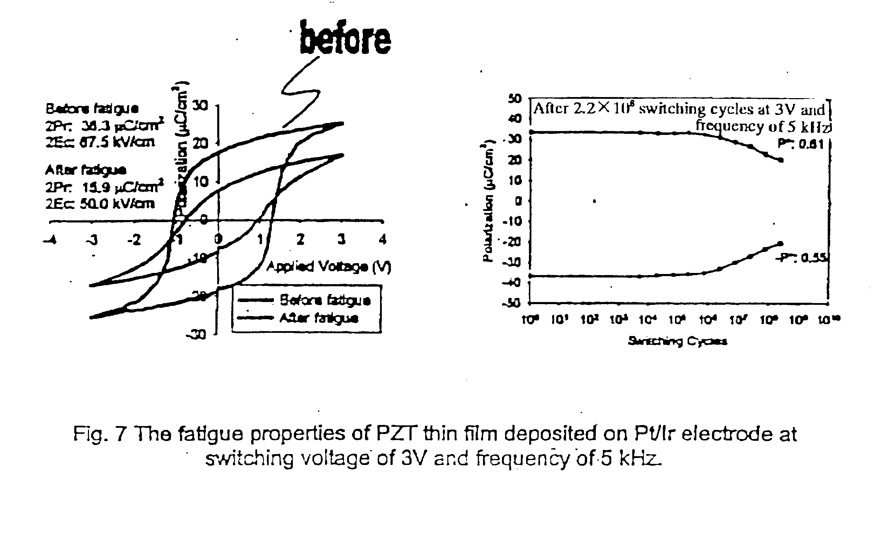

Figs. 5, 6, and 7 illustrate the fatigue behavior of PZT thin films on Ir, Pt and Pt/Ir electrodes at a switching voltage of 3V and frequency of 5 kHz. After 1x10⁸ switching cycles test, the normalized retained polarization of PZT thin films on Ir, Pt and Pt/Ir were 0.38, 0.76 and 0.58, respectively. Decreasing the switching frequency causes the fatigue rates of the PZT thin films deposited on Ir and Pt/Ir to increase.

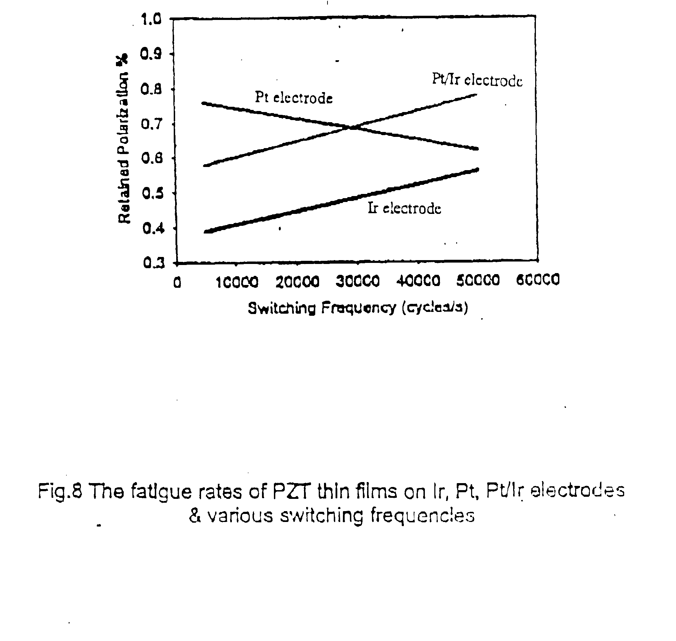

Fig. 8 illustrates that the fatigue rates of the PZT thin films on Pt decrease with decreasing switching frequency.

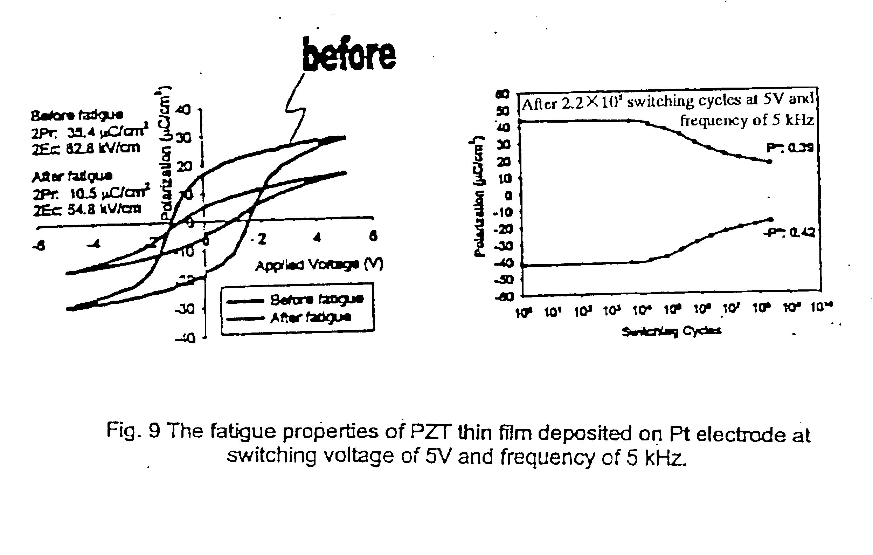

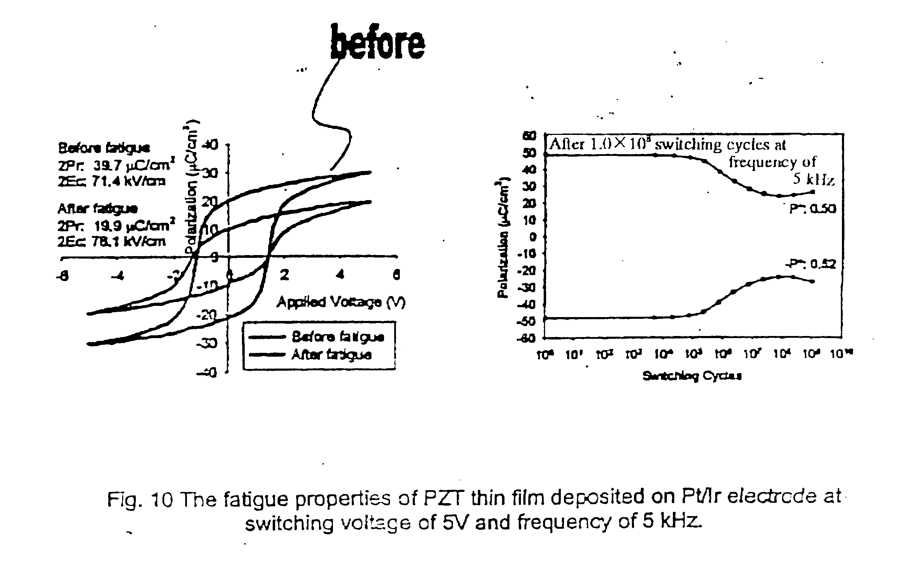

Figs. 9 and 10 illustrate the fatigue properties of PZT thin films deposited on Pt and Pt/Ir electrodes at a switching voltage of 5V and switching frequency of 5 kHz. Because of the higher leakage current, the hysteresis loops of PZT thin films on Ir electrodes can be only measured up to 4V.

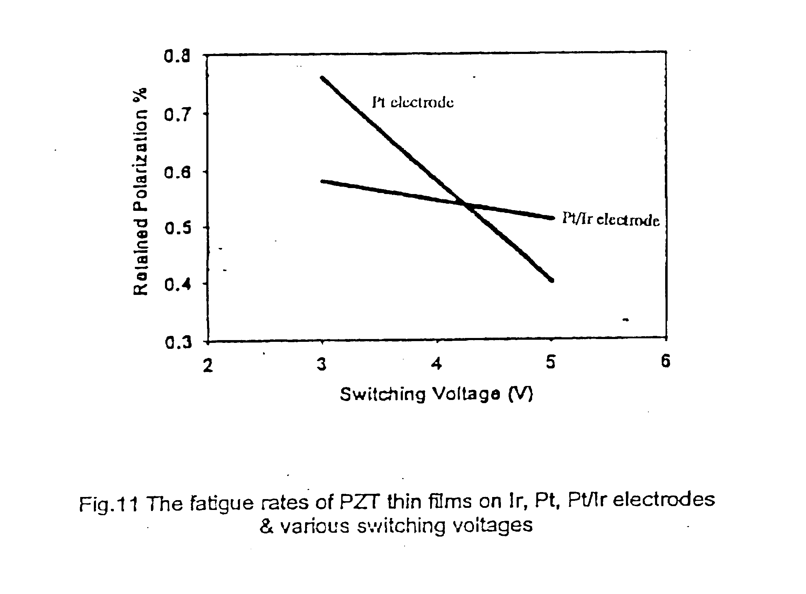

Fig. 11 illustrates that, compared with the data of the PZT films at a switching voltage of 3V, the fatigue rates of the PZT thin films deposited on both Pt and Pt/Ir increase with increasing switching voltage. For the Pt electrodes, the normalized retained polarization of PZT thin films decrease significantly from 0.75 to 0.4 with increasing switching voltage from 3V to 5V. For the Pt/Ir electrodes of the present invention, the normalized retained polarization of PZT thin films decrease significantly from 0.6 to 0.5 by increasing the switching voltage from 3V to 5V. The retained polarization of the PZT thin films deposited on Pt/Ir remains stable after 1x10⁸ cycles, until almost 1x10¹⁰ cycles (Fig. 10).

Polycrystalline PZT thin films with very good ferroelectric properties were deposited using MOCVD processes. The experimental processes and results are as stated below.

An EMCORE oxide MOCVD reactor with liquid delivery system was used for the growth of PZT thin films. The PZT films were deposited on 6" Pt (30nm)Ir(20nm)/Ti(25nm)/SiO₂(200nm)/Si using MOCVD processes. The precursors for PZT thin films listed in Table 2.

**Table 2**

| **PZT THIN FILM PROPERTIES** | | | |
|---|---|---|---|
| Precursors | Formula | Vapor Pressure (mm Hg) | Decomposition Temperature(°C) |
| Pb(TMHD)₂ | Pb(C₁₁H₁₉O₂)₂ | 180°C/0.05 | 325°C |
| Zr(TMHD)₄ | Zr(C₁₁H₁₉O₂)₄ | 180°C/0.1 | |
| Ti(IPO)₄ | Ti(C₈H₇O)₄ | 58°C/1 | |

[Pb(thd)₂], Zr(TMHD)₄ and Ti(IPO)₄ with a molar ratio of 1.2:0.5:0.5 were dissolved in a mixed solvent of butyl ether, isopropanol and tetraglyme in the molar ratio of 8:2:1. Alternately, tetrahydrofuran (THF) is used in place of butyl ether. The precursor solutions have a concentration of 0.1 M/L of PZT. The solution was injected into a vaporizer (200 - 250°C) by a pump at a rate of 0.1- 0.5 ml/min to form precursor gases. The precursor gases were brought into the reactor using a preheated argon flow at 200 - 250°C. The deposition temperatures and pressure are 500 - 650°C and 10 Torr separately. The shroud flow (Ar 4000 sccm) with oxygen (1000 - 2500 sccm) were led into the reactor. After deposition, the PZT thin films were cooled down to room temperature in a oxygen atmosphere. In order to improve the ferroelectric properties of PZT thin films, as-deposited PZT thin films were annealed at 600 - 700° C with a oxygen atmosphere before and after top electrode depositions.

The compositions of the PZT thin films were analyzed by using energy dispersion X-ray analysis (EDX). The phases of the films were identified using x-ray diffraction. The thickness and surface morphologies of the films on Pt/Ti/SiO₂/Si substrates were measured by Scanning Electronic Microscope. The ferroelectric properties were measured using a standardized RT66A tester.

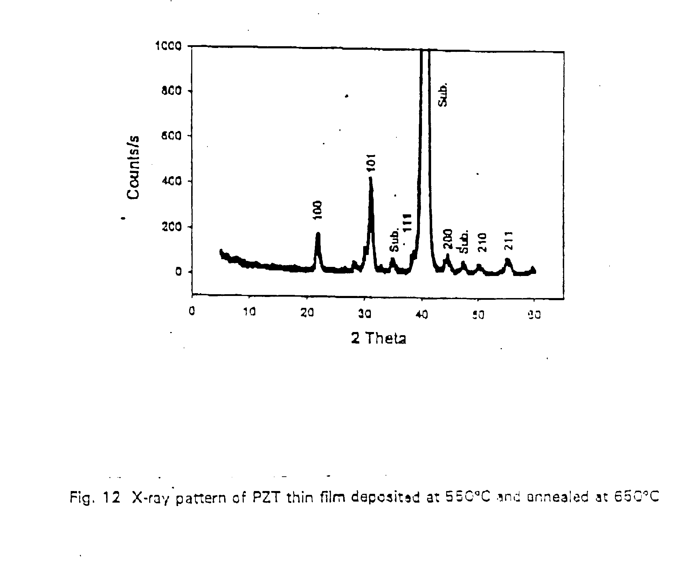

Fig. 12 illustrates the X-ray pattern of present invention PZT thin films deposited at 550°C and annealed at 650°C. The composition and phase measurements verify the formation of polycrystalline PZT thin films with a thickness of about 350 nm.

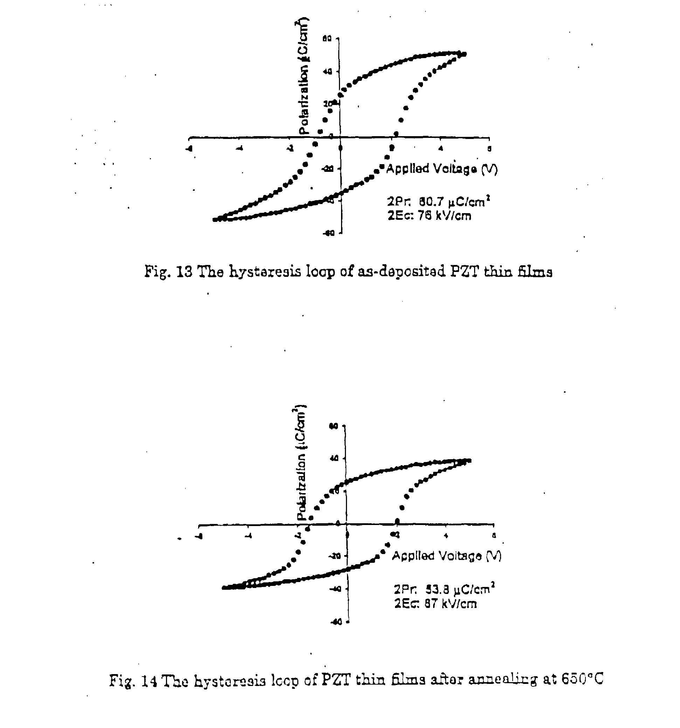

Fig. 13 shows that the hysteresis loop of as-deposited present invention PZT thin film with a 2Pr (polarization voltage) 60.7 µC/cm² and a 2Ec (coercion field) 76 kV/cm. The PZT thin films have very good ferroelectric and electrical properties after deposition by MOCVD processes.

Fig. 14 illustrates the hysteresis loop of present invention thin films after annealing at 650° C for 30 minutes. The 2Pr decreases to 53.8 µC/cm², 2Ec increases to 87 kV/cm, and the hysteresis loop is well saturated and symmetrical at an applied voltage of 5 V.

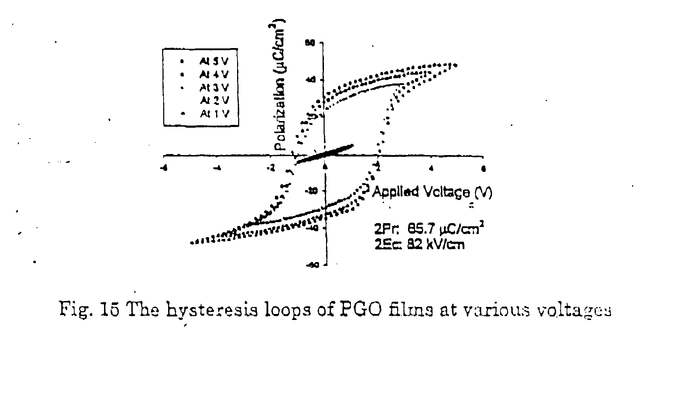

Fig. 15 illustrates the hysteresis loops of present invention thin films at various applied voltages. The hysteresis loop of the PZT thin film is almost saturated from 3 V.

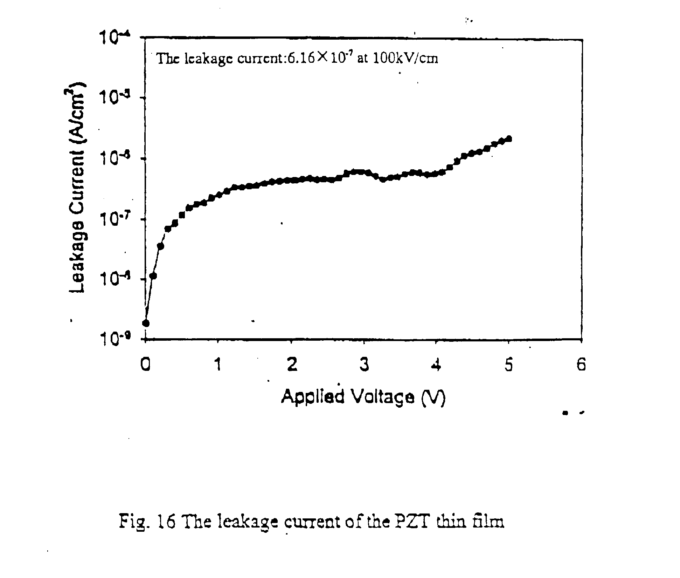

Fig. 16 illustrates the low leakage current of 6.16 x 10⁻⁷ A/cm² at 100 kV/cm of present invention thin films. The above experimental results confirm that it is possible to deposit high quality PZT thin films using MOCVD processes.

The epitaxial multilayer electrodes have been prepared by electrical beam evaporation techniques. First, 100 - 200 nm thick Ir electrodes were epitaxially grown on Ti/SiO₂/Si substrates at 100 - 250°C using a lower growth rate of 0.03 - 0.06 nm/s. Then, the very thin Pt electrode from 10 - 50 nm were epitaxial grown on Ir electrode at 100 - 250°C using a lower growth rate of 0.01 - 0.05 nm/s.

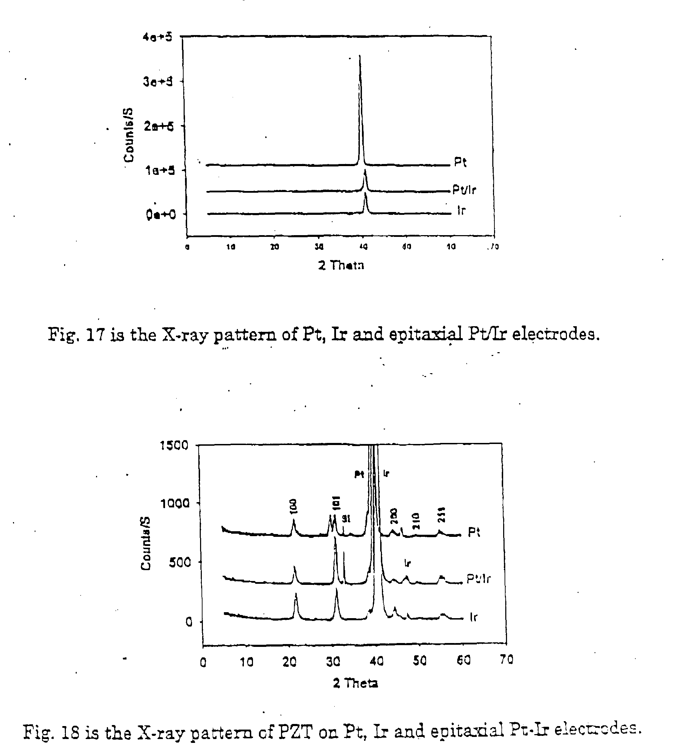

Fig. 17 is the X-ray pattern of Pt, Ir and epitaxial Pt/Ir electrodes. The X-ray patterns show the epitaxial Pt film grown on Ir substrate.

The compositions of the PZT thin films were analyzed by using energy dispersion X-ray analysis (EDX). The phases of the films were identified using x-ray diffraction. The thickness and surface morphologies of the films on the three kinds of substrates were measured by Scanning Electronic Microscope. The ferroelectric properties were measured using a standardized RT66A tester.

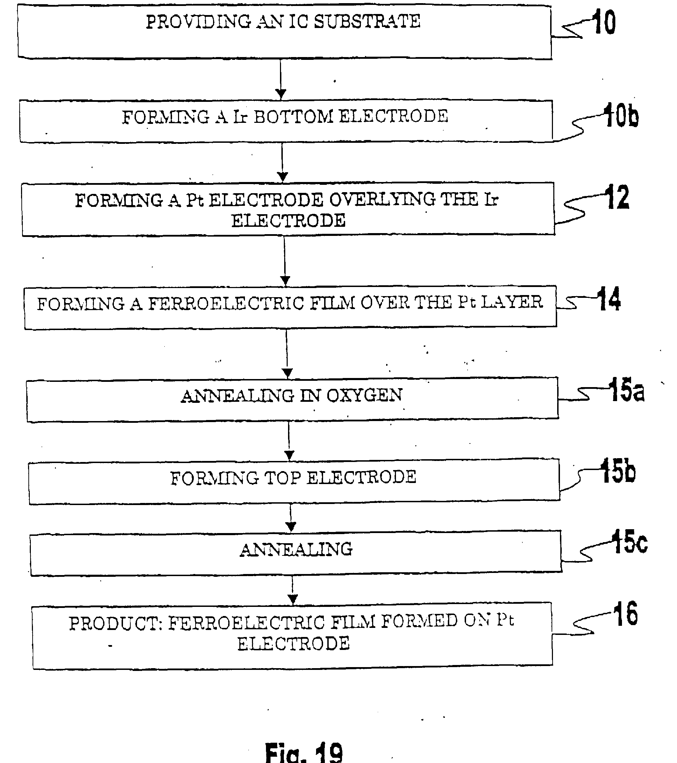

Fig. 18 is the X-ray patterns of PZT on Pt, Ir and epitaxial Pt-Ir electrodes. The X-ray patterns shows the pure PZT films grown on both of Ir and epitaxial Pt/Ir electrodes. The MOCVD PZT thin films on epitaxial Pt/Ir also show excellent ferroelectric and electrical properties.

Fig. 19 illustrates steps in a method for forming a ferroelectric film of the present invention in a ferroelectric device. Step 10 provides an integrated circuit substrate in a ferroelectric device. Step 12 forms a first bottom electrode layer of platinum (Pt) having a first adjusted crystalline lattice structure. It is understood, as stated herein, that an adjusted lattice structure is not the natural lattice structure associated with Pt. The adjusted lattice structure is a structure specifically designed to match the lattice structure of a ferroelectric film in its perovskite phase. Step 12 includes forming a Pt first bottom electrode layer at a temperature in the range of approximately 100 to 250 degrees C, with a growth rate in the range of approximately 0.1 to 0.5 Å per second. Step 12 includes the Pt first bottom electrode layer having a thickness in the range of approximately 100 to 1000 Å. Step 14 forms a single phase perovskite ferroelectric film overlying the first bottom electrode layer having a second crystalline lattice structure substantially the same as the first adjusted crystalline lattice structure. It is understood that the first adjusted and second lattice structures are not absolutely identical. The exact mismatch is difficult to quantify. However, the lattice mismatch is small enough to cause the formation of single phase perovskite ferroelectric film on Pt, similar to manner in which such a film would be grown on an Ir electrode. Step 14 includes the ferroelectric film being of a material selected from the group consisting of PZT, lead germanate (PGO), and SrBi₂Ta₂O₉ (SBT). In some aspects of the invention, Step 14 includes forming a PZT film having a film thickness of less than approximately 1 millimeter (mm). Step 16 is a product, where an electrode having ferroelectric properties is formed on a Pt electrode.

In some aspects of the invention, Step 14 includes orientationally or epitaxially growing the ferroelectric film from the Pt bottom electrode layer, whereby a perovskite ferroelectric film is formed on Pt at a low deposition temperature. As is well known in the art, "orientationally grown" implies a homogeneous polycrystalline structure with alignment in at least one axis, such as the c-axis. In the present invention a PZT film orientationally grown in the (110) orientation, while PGO is formed in the (001) orientation. However, orientationally grown structures may still have crystal boundary regions between crystals. "Epitaxially grown" implies an orientationally grown structure with a lack of such grain boundaries in the crystalline structure. Further, Step 12 includes orientationally or epitaxially growing the first bottom electrode layer from an underlying layer having a third crystalline lattice structure, which is substantially the same as the Pt first adjusted lattice structure. Again, the first adjusted and third lattice structures are not identical. Further, the first adjusted lattice structure is not constant. It changes in response to the thickness of the Pt layer, with the Pt nearest the third lattice structure having a lattice structure that more closely resembles the third lattice structure.

In some aspects of the invention, a further step precedes Step 12. Step 10a (not shown) forms a barrier layer of a material selected from the group consisting of titanium (Ti) and tantalum (Ta) overlying the silicon substrate, having a thickness in the range of approximately 100 to 500 Å. This step is not performed in every aspect of the invention. Step 10b forms a second bottom electrode layer of iridium (Ir) having the third crystalline lattice structure underlying the first bottom electrode layer. Step 10b includes the Ir second bottom electrode layer having a thickness in the range of approximately 1000 to 2000 Å. Step 10b includes forming the Ir second bottom electrode layer at a temperature in the range of approximately 100 to 250 degrees C, with a growth rate in the range of approximately 0.3 to 0.6 Å per second. Then, Step 12 includes epitaxially growing the first bottom electrode layer from the second bottom electrode layer.

Thus, the first adjusted lattice structure of the Pt in Step 12, is derived from the third lattice structure of the Ir deposited in Step 10b. The mismatch between the Ir and perovskite ferroelectric phase is very slight. As long as the Pt layer is thin enough, the Pt layer "adopts" the lattice structure of the underlying Ir. That is, as long as the Pt layer is thin enough, a Pt/Ir solid solution having an Ir lattice structure is formed, following a high temperature annealing. In some aspects of the invention it is useful to consider that a solid solution of Ir, with Pt atoms replacing some Ir atoms, or Pt atoms diffused into the Ir layer, is formed having the Ir lattice structure. If the Pt layer is thin, say 100 Å, the entire so-called Pt layer is considered to be such a solid solution. If the Pt layer is thicker, say 500 Å, then the Pt/Ir solid solution is interposed between the Ir layer and the Pt layer. Therefore, Step 12 includes forming a Pt and Ir solid solution, interposed between the first and second bottom electrode layers, having the third lattice structure.

In some aspects of the invention, Step 10 provides a silicon substrate and Step 10b includes orientationally or epitaxially growing the Ir second bottom electrode layer from the underlying silicon substrate.

In some aspects of the invention, Step 14 includes forming a PZT ferroelectric film with the following sub-steps (not shown):
a) mixing [Pb(thd)₂] and [Zr(TMHD)] and Ti(IPO)₄;
b) dissolving the mixture with a solvent selected from the group consisting of: a) tetrahydrofuran, isopropanol, and tetraglyme; and b) butyl ether, isopropanol, and tetraglyme;
c) heating the solution formed in sub-Step b) to create a precursor gas; and
d) decomposing the precursor gas formed in sub-Step c) on the IC wafer to form a PZT thin film, whereby the epitaxially grown PZT film has ferroelectric properties.

In some aspects of the invention, sub-Step a) includes mixing [Pb(thd)₂] and [Zr(TMHD)] and Ti(IPO)₄ in a molar ratio of approximately 1.2:0.5:0.5, respectively. In other aspects of the invention, sub-Step b) includes the solvents being in a molar ratio of approximately 8:2:1, respectively. Further, sub-Step b) includes forming a precursor solution having a concentration of approximately 0.1 moles of PZT mixture per liter of solvent.

When Step 10 provides a liquid pump and precursor vaporizer, then Step 14b includes using the liquid pump to introduce the precursor solution to the precursor vaporizer in Step 14c at a rate of approximately 0.5 milliliters per minute (ml/min). Further, Step 14c includes using the precursor vaporizer to heat the precursor solution to a temperature in the range of approximately 200 to 250 degrees C, whereby the precursor gas is formed.

When Step 10 provides that the IC wafer is located in a reactor, then further sub-steps follow Step 14c), and precede Step 14d. Step 14c₁ (not shown) mixes the precursor gas in the chamber with an argon gas shroud flow in the range of approximately 4000 to 6000 standard cubic centimeters per minute (sccm), preheated to a temperature in the range of approximately 170 to 250 degrees C. Step 14c₂ (not shown) introduces an oxygen flow to the reactor in the range of approximately 1000 to 2500 sccm.

When Step 10 provides that the IC wafer is located on a wafer chuck in a reactor, Step 14c includes establishing a precursor vapor pressure in the range of approximately 30 to 100 torr (T). Further, Step 14d includes heating the wafer chuck to a temperature in the range of approximately 500 to 700 degrees C and establishing a reactor chamber pressure in the range of approximately 5 to 20 T.

When Step 10 provides that a ferroelectric capacitor is formed, and Step 14 includes forming a PZT ferroelectric film, then further steps follow Step 14. Step 15a anneals the PZT film in an oxygen atmosphere at a temperature in the range between 600 and 750 degrees C. Step 15b forms a conductive electrode overlying the ferroelectric film. Step 15c anneals, whereby a capacitor with top and bottom electrodes is formed. In some aspects of the invention, the top electrode is an Ir/Pt layered electrode, fabricated as the Pt/Ir bottom electrode. In some aspects of the invention, Steps 15a and 15c include the oxygen being introduced at a partial pressure greater that approximately 20%. Further, Steps 15a and 15c include using annealing methods selected from the group consisting of furnace annealing at a temperature in the range of approximately 600 to 750 degrees C for a duration of approximately 30 minutes to 2 hours, and rapid thermal annealing (RTA) at a temperatures in the range of approximately 600 to 800 degrees C.

In some aspects of the invention, Steps 15a and 15c include the RTA process having a duration in the range of approximately 10 to 1800 seconds, and a thermal temperature ramp-up in the range of approximately 10 to 200 degrees C per second.

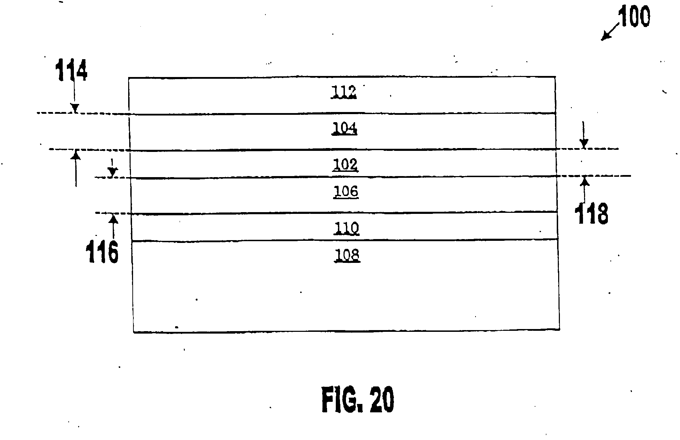

Fig. 20 illustrates a completed ferroelectric device of the present invention. Ferroelectric device 100 comprises a first bottom electrode layer 102 of orientationally or epitaxially grown platinum (Pt) having a first adjusted crystalline lattice structure. The adjusted Pt lattice structure is as described above in the explanation of Fig. 19. A single phase perovskite ferroelectric film 104 overlies first bottom electrode layer 102. Ferroelectric film 104 has a second crystalline lattice structure substantially the same as the first adjusted crystalline lattice structure, whereby the device has both good ferroelectric properties and low leakage current. Ferroelectric film 104 is a material selected from the group consisting of PZT, lead germanate (PGO), and SrBi₂Ta₂O₉ (SBT). Ferroelectric film 104 has a grain size in the range of approximately 0.5 to 5 microns.

A second bottom electrode layer 106 of iridium (Ir) underlies first bottom electrode layer 102. Second bottom electrode layer 106 has a third crystalline lattice structure substantially the same as the first adjusted lattice structure, whereby the Pt electrode layer has the lattice structure of the Ir electrode layer. As explained above in the description of Fig. 19, a solid solution of Pt and Ir (not shown), having an Ir lattice structure, is formed between first bottom electrode 102 and second bottom electrode 106.

A substrate 108 underlies second bottom electrode layer 106. In some aspects of the invention, substrate 108 is a silicon substrate, whereby the ferroelectric device is fabricated on silicon for use in an integrated circuit (IC).

Optionally, a barrier layer 110 is interposed between silicon substrate 108 and second bottom electrode layer 106. Barrier layer 110 includes a material selected from the group consisting of titanium (Ti) and tantalum (Ta).

Some aspects of the invention further comprise a top electrode 112 overlying ferroelectric film 104, whereby a capacitor is formed. The leakage current of the capacitor formed is approximately 1 x 10⁻⁷ A/cm² at 100 kV, the polarization lower voltage is approximately 3 V, and the saturation voltage is in the range of approximately 2 to 5 V.

Ferroelectric film 104 has a thickness 114 in the range of 1000 to 8000 Å. Ir second bottom electrode layer 106 has a thickness 116 in the range of approximately 1000 to 2000 Å. Pt first bottom electrode layer 102 has a thickness 118 in the range of approximately 100 to 1000 Å.

A ferroelectric film is provided which can be formed into a single phase perovskite film, on a Pt electrode, at low deposition temperatures. The insertion of a layer of Pt between the ferroelectric film and the underlying Ir bottom electrode, dramatically improves the leakage current. Also provided is a deposition method for forming the single-phase perovskite film on the Pt bottom electrode. Other embodiments and variations of the above-mention ferroelectric film, ferroelectric device structure, and formation methods will occur to those skilled in the art, in response to the provision the above-cited invention.

## Claims

1. In an integrated circuit ferroelectric device, a method for forming a ferroelectric film, the method comprising the steps of:
a) forming a first bottom electrode layer of platinum (Pt) having a first adjusted crystalline lattice structure; and
b) forming a single phase perovskite ferroelectric film overlying the first bottom electrode layer having a second crystalline lattice structure substantially the same as the first adjusted crystalline lattice structure, whereby an electrode having ferroelectric properties is formed on a Pt electrode.

2. The method as in claim 1 in which Step b) includes epitaxially growing the ferroelectric film from the Pt bottom electrode layer, whereby a perovskite ferroelectric film is formed on Pt at low deposition temperatures.

3. The method as in claim 1 in which Step a) includes epitaxially growing the first bottom electrode layer from an underlying layer having a third crystalline lattice structure which is substantially the same as the Pt first adjusted lattice structure.

4. The method as in claim 3 including a further step preceding Step a), of:
a1) forming a second bottom electrode layer of iridium (Ir) having the third crystalline lattice structure underlying the first bottom electrode layer; and
in which Step a) includes epitaxially growing the first bottom electrode layer from the second bottom electrode layer.

5. The method as in claim 4 wherein a silicon substrate is provided, and in which Step a1) includes epitaxially growing the Ir second bottom electrode layer from the underlying silicon substrate.

6. The method as in claim 5 including a further step, preceding Step a1), of:
a2) forming a barrier layer of a material selected from the group consisting of titanium (Ti) and tantalum (Ta) overlying the silicon substrate having a thickness in the range of approximately 100 to 500 Å .

7. The method as in claim 4 in which Step a) includes forming a Pt and Ir solid solution, interposed between the first and second bottom electrode layers, having the third lattice structure.

8. The method as in claim 4 in which Step a1) includes the Ir second bottom electrode layer having a thickness in the range of approximately 1000 to 2000 Å.

9. The method as in claim 4 in which Step a1) includes forming the Ir second bottom electrode layer at a temperature in the range of approximately 100 to 250 degrees C, with a growth rate in the range of approximately 0.3 to 0.6 Å per second.

10. The method as in claim 1 in which Step b) includes the ferroelectric film being of a material selected from the group consisting of PbZr₁₋ₓTiₓO₃ (PZT), lead germanate (PGO), and SrBi₂Ta₂O₉ (SBT).

11. Tha method as in claim 1 in which Step a) includes forming a Pt first bottom electrode layer at a temperature in the range of approximately 100 to 250 degrees C, with a growth rate in the range of approximately 0.1 to 0.5 Å per second.

12. The method as in claim 1 in which Step a) includes the Pt first bottom electrode layer having a thickness in the range of approximately 100 to 1000 Å.

13. The method as in claim 1 in which Step b) includes forming a PZT ferroelectric film as follows:
1) mixing [Pb(thd)₂] and [Zr(TMHD)] and Ti(IPO)₄;
2) dissolving the mixture with a solvent selected from the group consisting of: a) tetrahydrofuran, isopropanol, and tetraglyme; and b) butyl ether, isopropanol, and tetraglyme;
3) heating the solution formed in sub-Step 2) to create a precursor gas; and
4) decomposing the precursor gas formed in sub-Step 3) on the IC wafer to form a PZT thin film, whereby the epitaxially grown PZT film has ferroelectric properties.

14. The method as in claim 13 in which Step b)1) includes mixing [Pb(thd)₂] and [Zr(TMHD)] and Ti(IPO)₄ in a molar ratio of approximately 1.2:0.5:0.5, respectively.

15. The method as in claim 13 in which Step b)2) includes the solvents being in a molar ratio of approximately 8:2:1, respectively.

16. The method as in claim 13 in which Step b)2) includes forming a precursor solution having a concentration of approximately 0.1 moles of PZT mixture per liter of solvent.

17. The method as in claim 13 wherein a liquid pump and precursor vaporizer are provided, in which Step b)2) includes using the liquid pump to introduce the precursor solution to the precursor vaporizer in Step b)3) at a rate of approximately 0.5 milliliters per minute (ml/min), and in which Step b)3) includes using the precursor vaporizer to heat the precursor solution to a temperature in the range of approximately 200 to 250 degrees C, whereby the precursor gas is formed.

18. The method as in claim 13 in wherein the IC wafer is located in a reactor, and a further steps, following Step b)3), and preceding Step b)4), of:
b)3ₐ) mixing the precursor gas in the chamber with an argon gas shroud flow in the range of approximately 4000 to 6000 standard cubic centimeters per minute (sccm), preheated to a temperature in the range of approximately 170 to 250 degrees C; and
b)3_{b}) introducing an oxygen flow to the reactor in the range of approximately 1000 to 2500 sccm.

19. The method as in claim 18 wherein the IC wafer is located on a wafer chuck in a reactor, in which Step b)3) includes establishing a precursor vapor pressure in the range of approximately 30 to 100 torr (T), and in which Step b)4) includes heating the wafer chuck to a temperature in the range of approximately 500 to 700 degrees C and establishing a reactor chamber pressure in the range of approximately 5 to 20 T.

20. The method as in claim 1 wherein a ferroelectric capacitor is formed, in which Step b) includes forming a PZT ferroelectric film, and including further steps following Step c) of:
d) annealing the PZT film in an oxygen atmosphere at a temperature in the range between 600 and 750 degrees C;
e) forming a conductive electrode overlying the ferroelectric film; and
f) annealing, whereby a capacitor with top and bottom electrodes is formed.

21. The method as in claim 20 in which Steps d) and f) include the oxygen being introduced at a partial pressure greater than approximately 20%.

22. The method as in claim 20 in which Steps d) and f) include using annealing methods selected from the group consisting of furnace annealing at a temperature in the range of approximately 600 to 750 degrees C for a duration of approximately 30 minutes to 2 hours, and rapid thermal annealing (RTA) at a temperatures in the range of approximately 600 to 800 degrees C.

23. The method as in claim 20 in which Steps d) and f) include the RTA process having a duration in the range of approximately 10 to 1800 seconds, and a thermal temperature ramp-up in the range of approximately 10 to 200 degrees C per second.

24. The method as in claim 1 in which Step b) includes forming a PZT film having a film thickness of less than approximately 1 millimeter (mm).

25. A ferroelectric device comprising:
a first bottom electrode layer of epitaxially grown platinum (Pt) having a first adjusted crystalline lattice structure;
a single phase perovskite ferroelectric film overlying said first bottom electrode layer having a second lattice structure substantially the same as the first adjusted crystalline lattice structure, whereby the device has both good ferroelectric properties and low leakage current; and
a second bottom electrode layer of iridium (Ir) underlying said first bottom electrode layer having a third crystalline lattice structure substantially the same as the first adjusted lattice structure, whereby the Pt electrode layer has the lattice structure of the Ir electrode layer.

26. The ferroelectric device of claim 25 further comprising:
a silicon substrate underlying said second bottom electrode layer, whereby the ferroelectric device is fabricated on silicon for use in an integrated circuit (IC).

27. The ferroelectric device of claim 26 further comprising:
a barrier layer, including a material selected from the group consisting of titanium (Ti) and tantalum (Ta), interposed between said silicon substrate and said second bottom electrode layer.

28. The ferroelectric device of claim 25 in which said ferroelectric film is a material selected from the group consisting of PbZr₁₋ₓTiₓO₃ (PZT), lead germanate (PGO), and SrBi₂Ta₂O₉ (SBT).

29. The ferroelectric device of claim 25 further comprising a top electrode overlying said ferroelectric film, whereby a capacitor is formed.

30. The ferroelectric film of claim 29 in which the leakage current is approximately 1 x 10⁻⁷ A/cm² at 100 kV, the polarization lower voltage is approximately 3 V, and the saturation voltage is in the range of approximately 2 to 5 V.

31. The ferroelectric device of claim 25 in which said ferroelectric film has a thickness in the range of 1000 to 8000 Å.

32. The ferroelectric device of claim 25 in which said Ir second bottom electrode layer has a thickness in the range of approximately 1000 to 2000 Å.

33. The ferroelectric device of claim 25 in which said Pt first bottom electrode layer has a thickness in the range of approximately 100 to 1000 Å.

34. The ferroelectric film of claim 25 in which said ferroelectric film has a grain size in the range of approximately 0.5 to 5 microns.
